## Europäisches Patentamt

## European Patent Office

## Office européen des brevets

(19)

(11) Veröffentlichungsnummer: **0 159 416**
**A2**

(12) # EUROPÄISCHE PATENTANMELDUNG

(21) Anmeldenummer: **84116413.0**

(22) Anmeldetag: **27.12.84**

(51) Int. Cl.⁴: **H 05 K 13/00**

(30) Priorität: **12.04.84 DE 3413837**

(43) Veröffentlichungstag der Anmeldung: **30.10.85**
**Patentblatt 85/44**

(84) Benannte Vertragsstaaten: **AT BE CH DE FR GB IT LI NL**

(71) Anmelder: **Wacker-Chemitronic Gesellschaft für Elektronik-Grundstoffe mbH,**
**Johannes-Hess-Strasse 24, D-8263 Burghausen (DE)**

(72) Erfinder: **Voss, Jürgen, Dr. Dipl.-Cem.,**
**Schellingstrasse 16, D-8263 Burghausen (DE)**
Erfinder: **Dombkowski, Otto, Dipl.-Ing.,**
**Wieshäuserstrasse 3, D-8347 Kirchdorf/Inn (DE)**
Erfinder: **Kudlich, Walter, Dipl.-Ing., Haydnstrasse 14,**
**D-8263 Burghausen (DE)**
Erfinder: **Stodulka, Jan, Stadtplatz 57, D-8261 Tittmoning**
**(DE)**

(54) **Verpackung für Halbleiterscheiben.**

(57) Es wird eine automatenkompatible, dreiteilige Verpackung für Halbleiterscheiben angegeben, die aus einem Scheibenträger besteht, welcher von einem Boden und einem Deckel umgeben ist. Die Fixierung der Scheiben erfolgt in der Regel an vier Auflagepunkten; und zwar im Scheibenträger durch zwei Reihen von tangential zur Scheibe angeordneten Federzungen, im Deckel durch zwei Reihen von Haltekegeln.

WACKER-CHEMITRONIC       München, den 10.04.1984
Gesellschaft für Elektronik       PAT/Dr.K/hu
Grundstoffe mbH       Wa-Ch 8302
==========

## Verpackung für Halbleiterscheiben

Die Erfindung betrifft eine Verpackung für Halbleiterscheiben
in der Art des Oberbegriffes des Anspruches 1.

An Verpackungen für Halbleiterscheiben werden besonders hohe
Anforderungen gestellt. Es wird verlangt, daß sie zuverlässigen
Schutz der Scheiben gegen Verunreinigungen, z. B. durch Staub,
Luftfeuchtigkeit, oder das Verpackungsmaterial selbst gewährleisten. Sie müssen weiterhin wegen der Empfindlichkeit der
Scheiben gegenüber Bruch und Oberflächenbeschädigungen mechani-.
sche Beanspruchungen weitestgehend verhindern. Daneben wird
von einer solchen Verpackung geringes Gewicht und niedriger
Platzbedarf erwartet, um kostengünstigen Transport und raumsparende Lagerung zu ermöglichen. Zunehmend wichtig ist
schließlich die Forderung, daß solche Verpackungen automatenkompatibel sind, d. h. daß die Scheiben direkt und ohne vorheriges, langwieriges Umpacken in eigene Prozeßhorden aus
der Verpackung in den jeweils vorgesehenen, in der Regel automatisierten Weiterverarbeitungsschritt eingeschleust werden
können.

Insbesondere aufgrund der letztgenannten Forderung hat sich
für die gebräuchlichen Verpackungen von Halbleiterscheiben
meist ein Aufbau aus drei Teilen durchgesetzt, wobei in der
Regel ein aus Boden und Deckel bestehender Außenbehälter einen die Scheiben aufnehmenden Scheibenträger umschließt. Um die universelle Einsetzbarkeit solcher Scheibenträger zu gewährleisten, wurde vom "Semiconductor Equipment and Materials Institute (SEMI)" eine Norm erarbeitet, welche charakteristische Größen der Scheibenträger festlegt (vgl. E 1 SEMI Specification for Wafer Carriers, Published: January 1981, Revised: August 1981). Beispielsweise wird durch diese Norm die Form der Ober- und Stirnseite des Scheibenträgers oder die Anzahl und der durch Führungsrippen bestimmte Abstand der Scheiben im Träger vorgegeben.

Die bekannten, der SEMI-Norm entsprechenden Verpackungen weisen allerdings schwerwiegende Nachteile auf, wie z. B. hohes Gewicht, fehlende Stapelbarkeit, fehlende Kontrollmöglichkeit des Inhalts bei geschlossener Verpackung, mangelhafte Fixierung der Scheiben oder Verunreinigungen, insbesondere durch Abrieb an den Kontaktflächen zwischen Scheiben und Verpackung. Das letztgenannte Problem tritt vor allem in den Fällen auf, wo die Scheiben durch zu den Führungsrippen annähernd parallele Federzungen gehalten werden. Dabei ergibt sich beim Einlegen der Scheiben eine weite Auslenkung der Federzungen und ein dementsprechend starker Abrieb.

Aufgabe der Erfindung war es daher, eine Verpackung für Halbleiterscheiben anzugeben, die die Anforderungen der SEMI-Norm erfüllt und zugleich die Nachteile der bekannten Verpackungen vermeidet.

Gelöst wird diese Aufgabe durch eine Verpackung in der Art des kennzeichnenden Teils des Anspruchs 1.

Als Werkstoffe für die Herstellung der beiden Außenteile der Verpackung eignen sich allgemein Thermoplaste, also feste, nicht homogen vernetzte, überwiegend lineare Hochpolymere, die bei höheren Temperaturen reversibel weich und formbar werden und keine Zusatzstoffe enthalten, die bei Migration aus dem Material zu einer Qualitätsminderung der verpackten Scheiben führen können. Geeignet sind daher beispielsweise Polyolefine, Polyamide, lineare Polyester, Polyurethane, Polystyrol und insbesondere Polyvinylchlorid, vorzugsweise in der Form von beispielsweise schlagzähem, sog. Hart-PVC.

Zweckmäßig werden die Außenteile aus einer 1,0 bis 2,0 mm dicken Folie hergestellt, wobei in der Regel das Spritzguß- oder, günstiger, das Thermoformverfahren infrage kommen. Dabei wird zumindest die Abdeckung, im allgemeinen aber der gesamte Außenbehälter aus transparentem Kunststoff gefertigt, um die Kontrolle des Verpackungsinhalts zu erleichtern.

Für den am günstigsten nach dem Spritzgußverfahren gefertigten Scheibenträger kommen als Werkstoffe allgemein gegenüber den Scheiben chemisch inerte, thermoplastische, vorzugsweise teilkristalline Kunststoffe infrage. Solche Kunststoffe stehen beispielsweise in Form von Polytetrafluorethylen, Polytrifluor-chlorethylen, oder Polypropylen bzw. Polyethylen zur Verfügung, welche bevorzugt zum Einsatz kommen.

Im folgenden wird die Erfindung anhand der Figuren 1 bis 10 näher erläutert.

Fig. 1 zeigt die Verpackung von der Stirnseite (rechte Hälfte) und im Querschnitt (linke Hälfte)

Fig. 2 zeigt die Verpackung von der Längsseite, wobei ein Ausschnitt am linken Rand im Querschnitt dargestellt ist.

Fig. 3 bis Fig. 10 zeigen konstruktive Einzelheiten, wie Eckengestaltung, Auflagepunkte, Führungsrippen, Federzungen und Haltekegel.

Einander entsprechende Elemente sind in den verschiedenen Figuren mit den gleichen Bezugszeichen versehen.

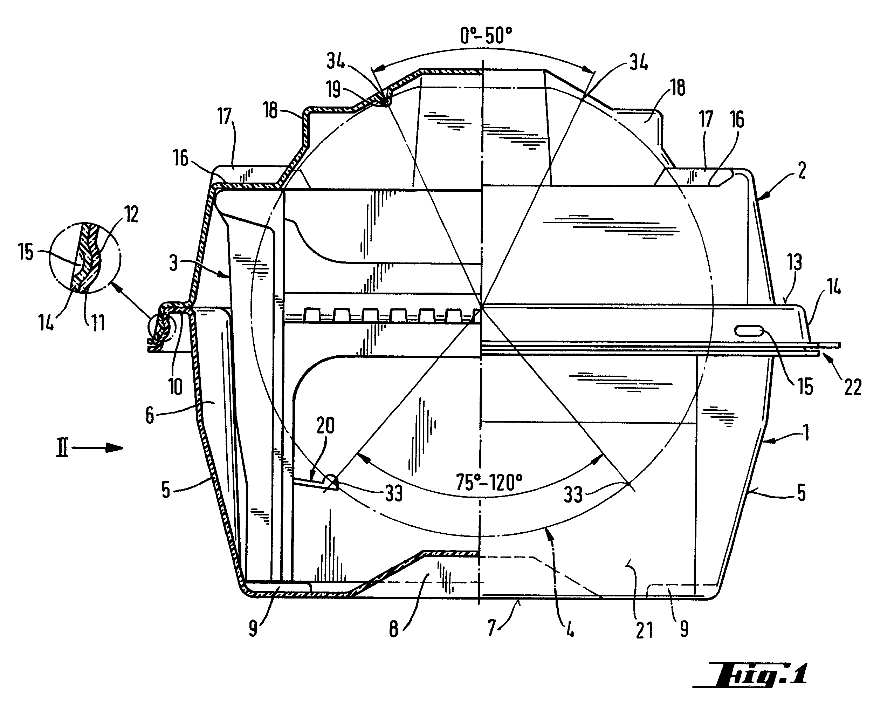

In Fig. 1 ist, von der Stirnseite, die erfindungsgemäße Verpackung dargestellt, die aus dem Boden 1 und dem Deckel 2 besteht, welche den Scheibenträger 3 mit einer nur angedeuteten Halbleiterscheibe 4 umgeben. Der Boden 1 besitzt sich nach oben erweiternde, zweckmäßig leicht geknickte Längsseitenwände 5, welche vorzugsweise hohlzylinderförmige Einbuchtungen 6 besitzen, die das seitliche Spiel des Scheibenträgers 3 begrenzen. Die ebene Standfläche 7 des Bodens 1 umgibt in Längsrichtung eine polygonartig nach innen gewölbte Einbuchtung 8. In die Standfläche 7 sind seitlich nach innen gezogene Auflageflächen 9 eingearbeitet, auf welche der Scheibenträger 3 zu stehen kommt. An seinem oberen Rand geht der Boden 1 in die vorzugsweise abgeflachte Bodenoberkante 10 und schließlich in den rinnenartig nach unten gezogenen Außenrand 11 über. Dieser besitzt im Bereich der, vorteilhaft gerundeten, Ecken an jeder Seitenfläche nach innen gewölbte Schnappkalotten 12.

Paßgerecht zum oberen Rand des Bodens 1 besitzt der Deckel 2 an seinem unteren Rand eine im allgemeinen ebene Auflagekante 13, an die sich die Umrandung 14 mit den nach innen gewölbten Schnappwülsten 15 im Eckenbereich anschließt. Gemäß einer bevorzugten Ausführungsform der Erfindung sind in die Bodenoberkante 10 hier nicht dargestellte Vertiefungen eingearbeitet, so daß Boden 1 und Deckel 2 nicht völlig dicht aufeinander sitzen, sondern Zwischenräume entstehen, welche den Druckausgleich zwischen dem Innenraum der Verpackung und der Umgebung erleichtern. Etwa auf halber Höhe umgibt den in seiner polygonartigen Wölbung der Scheibenkrümmung angepaßten Deckel 2 ein treppenartiger Absatz 16, der zur Höhenfixierung des Scheibenträgers 3 dient. Die diagonal in die Ecken weisenden Erhöhungen 17 sind wegen eines der SEMI-Norm entsprechenden Führungsstiftes am Scheibenträger 3 erforderlich. Eine weitere, zweckmäßig nur an den Längsseiten des Deckels angeordnete Stufe 18 vergrößert die Auflagefläche, wenn die Verpackungen aufeinander gestapelt werden und jeweils die Einbuchtung 8 des Bodens auf der paßgerecht gearbeiteten Deckelwölbung zu liegen kommt. Zwischen der Stufe 18 und der Scheitellinie des Deckels 2 ragen schließlich noch die Haltekegel 19 nach innen, die die Aufgabe haben, die Scheiben von oben her zu fixieren. Die Position der Haltekegel wird bevorzugt so gewählt, daß ihre Ansatzpunkte am Scheibenrand zur Scheibenmitte einen Winkel von 30° bis 50° bilden. Grundsätzlich sind jedoch auch kleinere Winkel, bis zum Grenzfall einer einzigen Halbkegelreihe entlang der Scheitellinie, möglich.

Der Scheibenträger 3 ist in Formgebung, z. B. in bezug auf die Gestaltung der Oberkante, und Ausstattung, z. B. in bezug auf Führungsrippen für die Scheiben und einen als "crossbar" bezeichneten Verbindungssteg an einer Schmalseite, weitgehend durch die SEMI-Norm vorgegeben. Erfindungsgemäß erfolgt die Fixierung der Halbleiterscheiben in ihm durch zwei Reihen von Federzungen 20, welche zwischen den Führungsrippen in der Weise angebracht sind, daß sie von einem bei einem Fünftel bis einem Drittel, vorzugsweise etwa einem Viertel der Seitenhöhe gelegenen Ansatzpunkt ausgehen. Zweckmäßig sind die Federzungen bereits in unbelastetem Zustand leicht, d. h. um 0° bis 30°, vorzugsweise 5° bis 10°, von der Waagerechten abweichend nach unten geneigt. Ihre Länge wird so.gewählt, daß ·die Auflagepunkte – streng genommen handelt es sich dabei natürlich
um Auflageflächen – der Scheiben mit dem Scheibenmittelpunkt
einen Winkel von 75° bis 120° bilden.

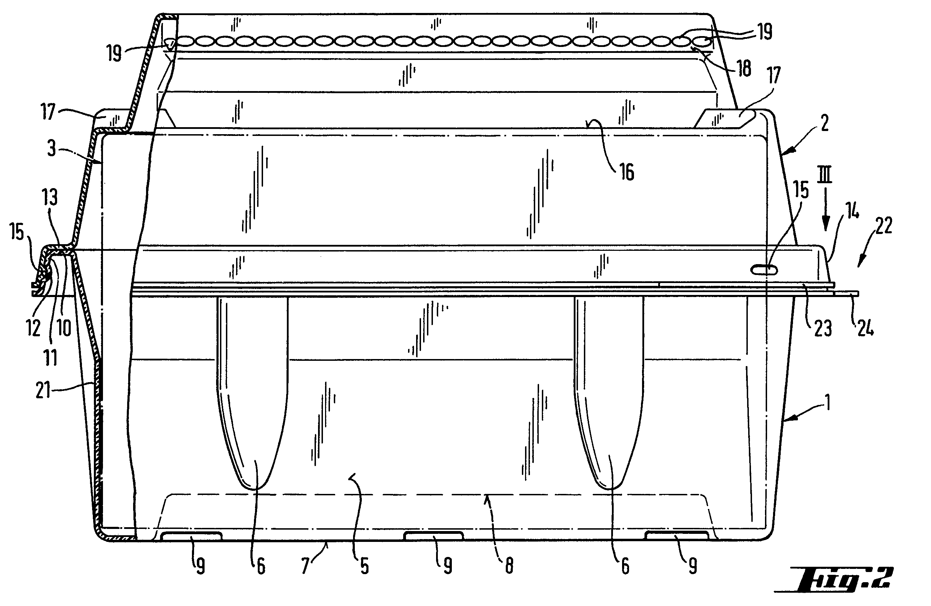

Die Fig. 2 macht beispielhaft deutlich, wie der Scheibenträger
3 im Boden 1 und Deckel 2 fixiert wird. Dies geschieht in
Querrichtung durch die Einbuchtungen 6 an den Längsseiten und
in Längsrichtung durch einen flächenförmigen Einzug 21 an den
Schmalseiten. Die Höhenfixierung erfolgt zum einen über die
Auflageflächen 9 im Boden 1, zum anderen über den Absatz 16
im Deckel. Scheibenträger 3, Boden 1 und Deckel 2 werden damit
in einer Position gehalten, in der jeweils einander entsprechende Führungsrippen, welche hier nicht dargestellt sind,
und Haltekegel 19 in einer Ebene liegen.

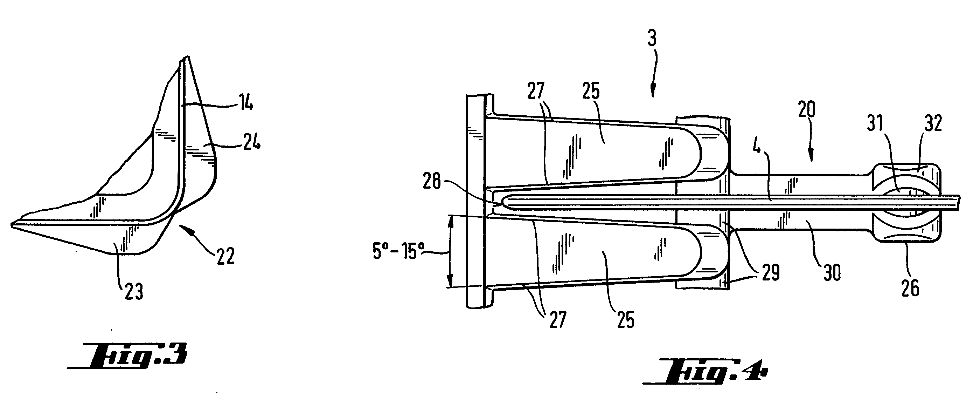

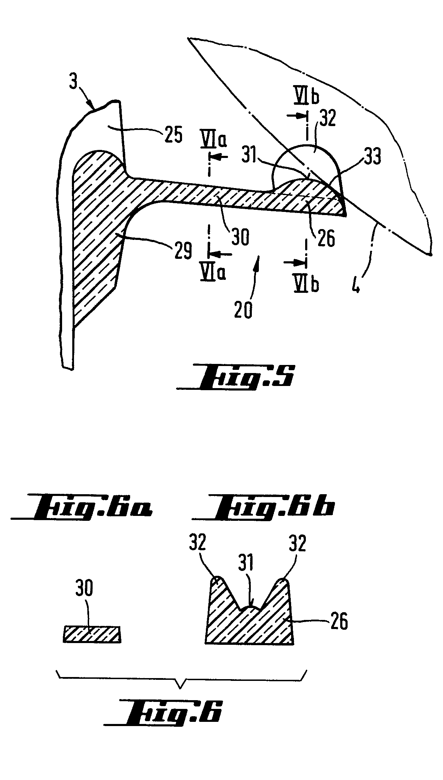

Fig. 3 zeigt in einer Draufsicht, wie zur Erleichterung des
Öffnens bei einer günstigen Ausführungsform der erfindungsgemäßen Verpackung an mindestens einer Ecke der in Fig. 1 und
Fig. 2 mit der Bezugsziffer 22 bezeichnete Bereich gestaltet
wird. Dabei läuft die Umrandung 14 des Deckels 2 in einer
oberen Lasche 23, der Außenrand 11 des Bodens 1 in einer unteren Lasche 24 aus. Beide Laschen sind um 90° versetzt angeordnet und erlauben durch eine einfache mit Daumen und Zeige-
.finger ausgeführte Drehbewegung, den Schnappverschluß an der
Ecke zu entriegeln.

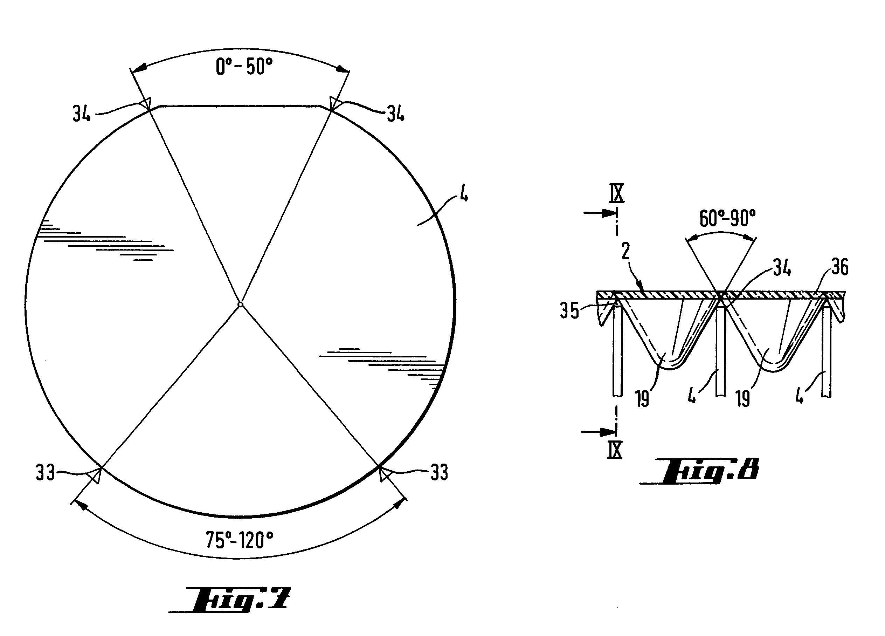

In Fig. 4 ist an einem Einzelbeispiel in einer Draufsicht dargestellt, wie sich bei geschlossener Verpackung die Halbleiterscheiben 4 zwischen den Führungsrippen 25 des Scheibenträgers 3
anordnen, wobei sie, ansonsten völlig freistehend, lediglich
am Kopfende 26 der Federzunge 20 in Kontakt mit dem Scheibenträger kommen. Der Winkel der Flanken 27 der Führungsrippen 25 zueinander beträgt 5° bis 15°, vorzugsweise etwa 7° und gewährleistet, daß beim Befüllen des Scheibenträgers 3 nur die
verrundete Kante 28 der Scheibe mit diesem in Kontakt kommen
kann. Die Federzungen 20 sind über den Federzungenschaft 29 mit
den Führungsrippen 25 verbunden.

Die Federzungen werden günstig wie in Fig. 5 und Fig. 6 dargestellt gestaltet. Gemäß Fig. 5 geht die Federzunge aus dem
zwischen den Führungsrippen 25 angeordneten Federzungenschaft
29 in den flachen Federzungenhals 30 über und endet in dem
Federzungenkopf 26. Dieser besteht aus der konvexen Auflagefläche 31 und den zu deren beiden Seiten angeordneten, gerundeten Führungselementen 32. Fig. 6 zeigt den Federzungenhals 30
und den Federzungenkopf 26 im Querschnitt. Im Federzungenkopf
26 fallen die höckerartigen Führungselemente 32 steil nach
innen zu der konvexen Auflagefläche 31 ab; die Neigung wird
günstig so steil gewählt, daß aufgrund der Schwerkraft der
Scheibenrand stets nach unten rutscht und auf der Auflagefläche 31
zu liegen kommt. Auf diese Weise ergibt sich eine minimale
Kontaktfläche 33 zwischen Scheibe 4 und Federzungenkopf 26 und
wegen der tangentialen Anordnung der Federzungen 20 auch eine
minimale Relativbewegung zwischen beiden, wenn die Scheiben
eingelegt oder entnommen werden. Damit kann die Gefahr von Abrieb besonders gering gehalten werden. Zweckmäßig werden die
Federzungenköpfe 26 so gestaltet, daß bei der Anordnung in
einer Reihe ihre Abstände voneinander so gering sind, daß die
Scheiben beim Einlegen nicht in die Zwischenräume geraten
können.

Fig. 7 zeigt die Punkte, an denen bei geschlossener Verpackung
Kräfte an einer Scheibe 4 angreifen und an denen gleichzeitig
überhaupt ein Kontakt Scheibe-Verpackung stattfindet. Die
Scheibe 4 liegt an den Kontaktflächen 33 auf den Federzungen 20

- 8 -

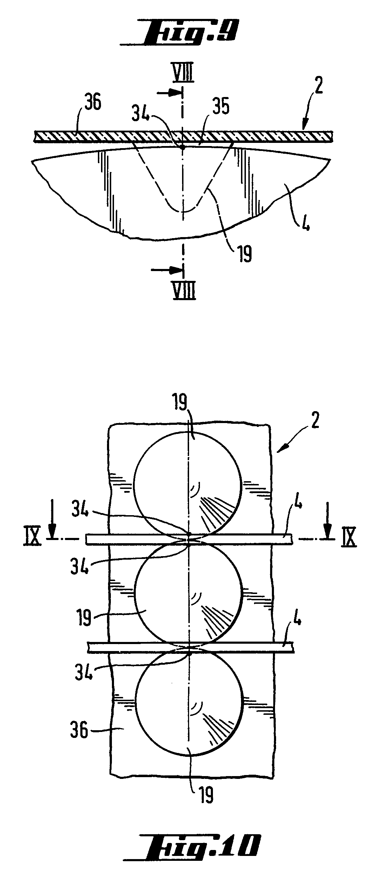

auf, wobei zum Scheibenmittelpunkt ein Winkel von 75° bis 120°
entsteht. Die Kräfte, mit der die Scheiben an die Federzungen
20 gedrückt werden, greifen an den Punkten 34 an, wo der
Scheibenrand im Bereich der nach innen ragenden Haltekegel 19
am Deckel 2 anliegt. Gemäß der bevorzugten Ausführungsform
bilden diese Punkte 34 zum Scheibenmittelpunkt einen Winkel von
30° bis 50°, so daß ihre Entfernung voneinander im allgemeinen
größer ist als der sog. "Scheibenflat", eine vielfach übliche,
zur Kennzeichnung der Orientierung am Scheibenumfang angebrachte
Abflachung. Gleichfalls möglich sind kleinere Winkel, d. h.
geringere Entfernungen der Punkte 34 voneinander bis hin zu dem
Grenzfall, daß bei 0° beide Punkte 34 zusammenfallen. Bei solchen Ausführungsformen ist jedoch beim Einlegen der Scheiben
darauf zu achten, daß der Scheibenflat stets neben den Punkten
34 zu liegen kommt. Die Fixierung durch die Reihe(n) der Haltekegel 19 ist in den Figuren 8, 9 und 10 näher erläutert.

Gemäß Fig. 8 erfolgt der Kontakt der Scheibe 4 mit den Haltekegeln 19 an den Punkten 34 in der Art, daß der Scheibenrand
an der Stelle den Deckel berührt, wo zwei benachbarte Haltekegel 19, deren Mantelfläche in einem Winkel von 60° bis 90°
zueinander stehen, aneinander stoßen. Dadurch wird, wie auch
aus Fig. 9 deutlich wird, erreicht, daß der äußere Rand der
Scheibe 4 durch einen Zwischenraum 35 von der Deckelwandung
36 getrennt bleibt.

Fig. 10 zeigt in einer Draufsicht eine Reihe von Haltekegeln 19
mit dazwischen befindlichen Scheiben 4. Der Abstand der Kegelmittelpunkte ist dabei gleich dem gewünschten Abstand der Scheiben voneinander und dem der Führungsrippen im Scheibenträger 3.

In der erfindungsgemäßen Verpackung werden die Scheiben damit
durch die Federwirkung des Deckels im Bereich der Haltekegelreihen, durch die Federwirkung der Federzungen, sowie letztlich durch die Haltekräfte der Schnappverschlüsse gehalten. Die
Fixierung hängt damit ausschließlich von den mechanischen und
Elastizitätseigenschaften des Verpackungsmaterials ab und nicht
von Druckdifferenzen zwischen Verpackungsinnenraum und der Umgebungsatmosphäre. Ohne Einfluß bleiben auch Schwankungen der
Scheibendurchmesser, sofern die üblichen Toleranzwerte nicht
überschritten werden.

Durch die Geometrie der gesamten Verpackung wird bei der bevorzugten Ausführungsform eine definierte Vierpunktauflage der
Scheiben 4 im Deckel 2 und im Scheibenträger 3 erreicht.
Auch in dem Fall, daß der Scheibenflat bei einem der Kontaktpunkte 34 zu liegen kommt, ist immer noch eine Fixierung mit
Hilfe von drei verbleibenden Haltepunkten gegeben. Selbst bei der
Ausführungsform mit nur einer Haltekegelreihe entlang der
Scheitellinie des Deckels 2 ist stets eine definierte Dreipunktauflage gewährleistet, wenn beim Einlegen der Scheiben eine
Position des Scheibenflats an einem der Punkte 34 oder 35 verhindert wird.

Die Verpackung wird nach dem Befüllen mit Halbleiterscheiben
zum Schutz von Verunreinigungen in einen zumeist mehrschichtigen Schutzfolienbeutel mit möglichst geringer Gas-, Luft-
bzw. Wasserdampfpermeabilität gegeben und, gegebenenfalls auch
nach Zufuhr von Schutzgas, bei in der Regel auf etwa 50 bis
500 hPa vermindertem Druck hermetisch versiegelt. Dadurch wird
das Aufblähen oder die Zerstörung des Schutzfoliensackes beim
Transport in Flugzeugen mit nur teilweisem Druckausgleich der
Frachtkabinen vermieden.

Ein besonderer Vorteil der Verpackung liegt neben dem geringen
Gewicht und den vergleichsweise niedrigen Kosten darin, daß sowohl die einzelnen Außenteile als auch die komplette Verpackung
stapelbar sind. Darüber hinaus kann der Scheibenträger nicht nur
bei der Lagerung, sondern auch bei manchen Weiterverarbeitungsschritten, z. B. gewissen Reinigungsprozessen, als Prozeßhorde
eingesetzt werden. Diese zusätzliche Einsatzmöglichkeit wird
dadurch begünstigt, daß wegen der Fixierung der Scheiben mit
Federzungen eine sehr offene Bauweise des Scheibenträgers mit
nahezu senkrecht abfallenden Führungsrippen und Seitenwänden
möglich ist.

Patentansprüche

1. Verpackung für Halbleiterscheiben, welche aus einem die
   Scheiben aufnehmenden, an der Ober- und Unterseite offenen,
   an beiden Längsseiten mit Führungsrippen und an der offenen
   Stirnseite mit einem Quersteg versehenen Scheibenträger,
   einem wannenförmigen, den Scheibenträger aufnehmenden Bodenteil sowie einem dem Scheibenumfang angepaßten, polygonartig
   gewölbten Deckel mit Vorsprüngen besteht, die mit Halteelementen im Scheibenträger formangepaßt zusammenwirken
   können, d a d u r c h   g e k e n n z e i c h n e t ,

   a) daß sie aus einem Scheibenträger besteht, der an beiden
      Längsseiten auf gleicher Höhe, die einem Fünftel bis einem
      Drittel der Seitenhöhe entspricht, jeweils zwischen den
      Führungsrippen Federzungen besitzt, welche mit einem von
      der Waagerechten um 0° bis 30° abweichenden Winkel nach
      unten ins Innere des Scheibenträgers weisen und deren
      Länge so gewählt wird, daß die Auflagepunkte der Scheiben
      mit dem Scheibenmittelpunkt einen Winkel von 75° bis
      120° einschließen,

   b) daß im Deckel in Reihe und spiegelsymmetrisch zur Scheitellinie einander an der Basis berührende, nach innen weisende Haltekegel angeordnet sind, deren Ansatzpunkte am
      Scheibenrand zur Scheibenmitte einen Winkel von 0° bis 50°,
      vorzugsweise 30° bis 50° bilden, wobei innerhalb der
      Reihe der Abstand der Mittelpunkte der Basisflächen benachbarter Haltekegel gleich dem Abstand der Führungsrippen im Scheibenträger ist und die Mantelflächen benachbarter Haltekegel zueinander einen Winkel von 60° bis 90°
      bilden,

   c) daß die Seitenflächen des Bodens Formelemente aufweisen,
      welche den Scheibenträger in Längs- und Querrichtung nahezu spielfrei fixieren;

d) daß Deckel und Boden mittels Schnappverschluß miteinander verbunden werden, wobei der Deckel mittels einer zur Scheibenträgeroberkante paßgerechten, treppenartigen Ausbuchtung den Scheibenträger in der Weise fixiert, daß einander entsprechende Führungsrippen und Führungskegel jeweils in einer Ebene angeordnet werden, so daß die Scheiben nur mit den Mantelflächen benachbarter Haltekegel und dem Vorderende der Federzunge in Kontakt kommen.

2. Verpackung nach Anspruch 1, d a d u r c h   g e k e n n - z e i c h n e t  ,   daß zumindest der Deckel aus transparentem Kunststoff gefertigt ist.

3. Verpackung nach den Ansprüchen 1 und 2, d a d u r c h   g e k e n n z e i c h n e t ,  daß die Federzungen an ihrem Ende zwei halbzylinderförmige Höcker aufweisen, die durch einen in Längsrichtung verlaufenden, V-förmigen Einschnitt, dessen Grundfläche konvex gekrümmt ist, getrennt werden.

4. Verpackung nach einem oder mehreren der Ansprüche 1 bis 3, d a d u r c h   g e k e n n z e i c h n e t ,  daß an der Kontaktfläche zwischen Boden und Deckel Ausnehmungen vorgesehen sind, die den Druckausgleich zwischen dem Innenraum der Verpackung und der Umgebung gestatten.

5. Verpackung nach einem oder mehreren der Ansprüche 1 bis 4, d a d u r c h   g e k e n n z e i c h n e t ,  daß an mindestens einer Ecke die Umrandung des Deckels und der Außenrand des Bodens in um 90° gegeneinander versetzten Laschen auslaufen.

Fig. 1

Fig.2

Fig. 3

Fig. 4

**Fig.5**

**Fig.6a**     **Fig.6b**

**Fig.6**

**Fig.8**

**Fig.7**

Fig.9

Fig.10